Europäisches Patentamt

European Patent Office

Office européen des brevets

(19)

(11) Numéro de publication: **0 070 233**

**A1**

## (12) DEMANDE DE BREVET EUROPEEN

(21) Numéro de dépôt: 82401273.6

(22) Date de dépôt: 06.07.82

(51) Int. Cl.³: **B 22 C 9/04**
**H 01 L 21/48**

(30) Priorité: 10.07.81 FR 8113678

(43) Date de publication de la demande:
19.01.83 Bulletin 83/3

(84) Etats contractants désignés:
DE GB IT

(71) Demandeur: **L.C.C.-C.I.C.E. - COMPAGNIE
EUROPEENNE DE COMPOSANTS ELECTRONIQUES
36, avenue Galliéni
F-93170 Bagnolet(FR)**

(72) Inventeur: **Taverdet, Jean-Claude
THOMSON-CSF SCPI 173, bld Haussmann
F-75379 Paris Cedex 08(FR)**

(72) Inventeur: **Lebailly, Michel
THOMSON-CSF SCPI 173, bld Haussmann
F-75379 Paris Cedex 08(FR)**

(74) Mandataire: **Jacquard, Philippe et al,
THOMSON-CSF SCPI 173, Bld Haussmann
F-75379 Paris Cedex 08(FR)**

(54) Procédé de fabrication d'un boîtier pour encapsulation de composants formant un circuit électrique.

(57) Procédé de fabrication d'un boîtier pour encapsulation de composants formant un circuit électrique, ce boîtier comportant une armature supportant les fils de connexion du circuit électrique et au moins un couvercle soudé sur l'armature. Selon l'invention, on réalise une pièce en cire (53) ayant la forme géométrique de l'armature (1) du boîtier, au moins une couche d'une solution d'un produit réfractaire étant ensuite déposée sur la surface de la pièce en cire (53) puis séchée afin de durcir ladite couche par évaporation du solvant, l'ensemble pièce en cire-produit réfractaire étant ensuite chauffé pour fondre la cire, le produit réfractaire étant ensuite fritté afin de constituer un moule de l'armature (1) dans lequel un métal est coulé par réaliser l'armature (1).

FIG_2

EP 0 070 233 A1

PROCEDE DE FABRICATION D'UN BOITIER POUR
ENCAPSULATION DE COMPOSANTS FORMANT
UN CIRCUIT ELECTRIQUE

L'invention concerne un procédé de fabrication d'un boîtier pour encapsulation de composants formant un circuit électrique, ce boîtier comportant une armature supportant les fils de connexion du circuit électrique et au moins un couvercle soudé sur l'armature. Le procédé de l'invention est plus particulièrement employé pour la réalisation de boîtier pour encapsulation de circuit de la micro-électronique hybride. De tels boîtiers comportent une armature métallique qui supporte les fils de connexion des circuits encapsulés. Les fils de connexion sont scellés hermétiquement sur l'armature grâce à des perles de verre fixées dans les trous de l'armature prévus à cet effet et traversées par les fils de connexion. La fermeture du boîtier est hermétique et réalisée par soudure électrique d'au moins un couvercle sur l'armature.

Selon les types de boîtier, les fils de connexion sont ou bien des clous généralement rigides, scellés sur l'armature et souvent espacés de 1,27 mm ou le plus couramment de 2,54 mm suivant les normes de câblage de la micro-électronique ou bien des lamelles métalliques qui constituent alors une grille de connexion dont le pas est normalisé et pratiquement de 1,02 mm ou 2,54 mm ou le plus couramment de 1,27 mm. Les lamelles métalliques sont scellées sur les parois latérales de l'armature.

L'armature des boîtiers est selon les cas, soit une cuvette, soit un cadre métallique. Dans le cas où l'armature est une cuvette, le boîtier ne comportera qu'un seul couvercle. Les fils de connexion pourront être scellés ou sur fond de la cuvette ou sur ses parois latérales. Dans le cas où l'armature est un cadre, le boîtier comportera deux couvercles soudés sur ledit cadre.

Il a déjà été proposé de réaliser de telle cuvette par emboutissage ou matriçage d'une pièce métallique qui prend, alors la forme générale de la cuvette. Ensuite, la pièce est travaillée afin de comporter les éléments nécessaires à la constitution du boîtier et en particulier des trous de scellement sont réalisés pour la fixation des fils de connexion suivant la configuration adaptée au circuit électronique encapsulé. Puis, les fils de connexion sont scellés par l'intermédiaire de perles de verre fixées dans les trous de scellement et la cuvette est recouverte d'une couche de métal qui peut être un alliage de nickel ou de l'or. Dans la cuvette ainsi réalisée, on place les circuits électriques à encapsuler puis on soude le couvercle sur la cuvette afin de rendre hermétique le boîtier. Ce procédé est plus particulièrement destiné au boîtier dont les fils de connexion sont des clous. Toutefois, un tel procédé présente l'inconvénient d'utiliser une infra-structure lourde et de comprendre des opérations demandant une certaine précision qui sont, par conséquent, longues à se dérouler. De plus, chacune des cuvettes est fabriquée indépendamment des autres cuvettes et aucune opération ne peut porter simultanément sur plusieurs cuvettes ce qui nuit à la fabrication en série de tels boîtiers.

Il a également été proposé de découper un cadre métallique selon la technique de découpage à la presse, puis de braser sur une préforme découpée dans une feuille de cuivre ou sous forme d'une pâte de cuivre un fond métallique sur ledit cadre métallique qui constitue, ainsi, une cuvette. La pièce est ensuite travaillée de la même façon que précédemment pour réaliser le boîtier répondant aux critères d'encapsulation d'un circuit électronique. Ce procédé est plus particulièrement destiné au boîtier dont les fils de connexion constituent une grille. Toutefois, un tel procédé présente des inconvénients similaires au procédé d'emboutissage et de matriçage. En effet, il utilise une infra-structure lourde et aucune opération ne porte simultanément sur plusieurs boîtiers.

Plus récemment, il a été proposé d'utiliser la technique d'usinage en commande numérique. L'armature et le boîtier d'encapsulation sont alors réalisés sous la commande d'un ordinateur selon la technique bien connue de l'homme de l'art. Toutefois, un tel procédé présente l'inconvénient d'utiliser un ordinateur et un matériel sophistiqué. L'usinage en commande numérique se justifie généralement pour la réalisation de petites séries de boîtiers prototypes où les moyens utilisés pour la fabrication du boîtier importent peu mais une production à plus grande échelle impose l'emploi de moyens adaptés. De plus, cet ordinateur et ce matériel sont coûteux et augmentent d'autant le prix de fabrication du boîtier. Enfin, chacune des cuvettes est également fabriquée indépendamment des autres cuvettes et aucune opération ne peut porter simultanément sur plusieurs cuvettes.

Le procédé de fabrication selon l'invention ne possède pas les inconvénients des procédés décrits ci-dessus, dans ce but, il est caractérisé en ce que l'on réalise une pièce en cire ayant la forme géométrique de l'armature du boîtier, au moins une couche d'une solution d'un produit réfractaire étant, ensuite, déposée sur la surface de la pièce en cire puis séchée afin de durcir ladite couche par évaporation du solvant, l'ensemble pièce en cire-produit réfractaire étant ensuite chauffé pour fondre la cire, le produit réfractaire étant ensuite fritté afin de constituer un moule de ladite armature dans lequel un métal est coulé afin de réaliser l'armature.

Le procédé de fabrication de l'invention permet donc de transférer le travail de modelage de l'armature sur la pièce en cire qui, par sa composition, est facilement modelable. Les formes géométriques de l'armature sont entièrement reproduites sur la pièce en cire, y compris les trous de scellement des fils de connexion. Une simple reprise d'usinage sur la face de fermeture de l'armature, les faces de référence et éventuellement le taraudage des trous de fixation du boîtier sont les seules opérations effectuées sur l'armature.

Afin de déposer une couche d'une solution d'un produit réfractaire sur la pièce en cire, ladite pièce est trempée dans un bain de ladite solution qui adhère à la surface extérieure de la pièce en cire et forme une fine couche dont l'épaisseur est par exemple 2/10 mm.

La pièce en cire enduite de la solution du produit réfractaire est sortie du bain puis placée en étuve où un courant d'air à une température voisine de l'ambiante sèche l'ensemble constitué par la pièce en cire et la solution du produit réfractaire, ce qui évapore le solvant et les adjuvents éventuels introduits dans la solution. Le produit réfractaire est, alors, sous forme d'une poudre dont les grains sont solidaires, rendant la couche de produit réfractaire suffisamment dure pour qu'une autre couche d'un produit réfractaire puisse être déposée sur sa surface. Il est, ainsi, possible de déposer successivement plusieurs couches de produit réfractaire par la séquence trempage dans une solution d'un produit réfractaire-séchage-trempage dans une solution d'un produit réfractaire-séchage- etc... Pratiquement, la solution du produit réfractaire est la même pour chacune des couches.

En fait, plusieurs pièces en cire sont trempées puis séchées par la même opération, les pièces en cire étant attachées sur un tourniquet qui est plongé dans ledit bain puis placé en étuve.

Afin d'adhérer à la pièce en cire, les solutions de produits réfractaires sont fixotropes, c'est-à-dire qu'au-dessous d'une certaine contrainte de cisaillement dite contrainte de cisaillement seuil, supérieure à l'accélération de la pesanteur, la viscosité reste approximativement constante par rapport à son accroissement au-dessus de la valeur de la contrainte de cisaillement seuil. La viscosité d'une telle solution, sans contrainte, est comprise entre 10 et 50 poises.

Le produit réfractaire de la solution de la première couche déposée sur la pièce en cire est, préférentiellement, constitué de grains de granulométrie comprise entre 1 µm et 10 µm. On appelle dans toute la suite de l'exposé première couche de produit réfractaire, la couche de produit réfractaire qui est en contact avec la pièce en cire. Une faible granulométrie de la première couche de produit réfractaire a le but de constituer un bon état de surface dudit moule. Ensuite, lorsque le métal est coulé dans le moule, il prend toutes les formes de la première couche de produit réfractaire et donc comporte les aspérités éventuelles de la première couche. Or, un bon état de surface de l'armature permet à l'armature d'être hermétique par effet de peau. En réalisant une première couche de produit réfractaire de granulométrie comprise entre 1 µm et 10 µm, une paroi de l'armature d'épaisseur 1 mm laisse filtrer pendant 1 seconde moins d'un centimètre-cube d'hélium maintenu sous une pression de $10^{-9}$ atmosphères. D'autre part, une telle granulométrie permet que les surfaces de l'armature soient planes à 2/100 mm. Les autres couches de produit réfractaire ont une granulométrie comprise entre 10 µm et 100 µm, l'importance d'une granulométrie faible étant moindre puisque la surface de l'armature n'est en contact que de la première couche du produit réfractaire.

On dépose, de préférence, entre 10 et 15 couches de produit réfractaire. L'épaisseur du moule en produit réfractaire est ainsi comprise entre 2 mm et 3 mm constituant une épaisseur suffisante quant à la solidité du moule.

Dans un mode préférentiel de réalisation, le procédé de fabrication selon l'invention est caractérisé en ce que la pièce en cire est réalisée par injection de cire dans un compartiment métallique, des éjecteurs sortant la pièce en cire dudit compartiment par poussée sur les faces supérieures des parois de la pièce en cire. Les faces supérieures desdites parois sont les faces sur lesquelles le couvercle fermant le boîtier est soudé. La poussée produite par les éjecteurs est de quelques bars mais est suffisante pour provoquer des déformations sur la pièce en cire si elle n'est pas appliquée uniformément. Dans le cas où l'armature est une cuvette, la poussée des éjecteurs sur le fond de la pièce en cire amène la présence de surélévations du fond de la cuvette qui détruisent sa planéité. Lorsque des circuits électriques sont ensuite collés sur le fond de la cuvette, il est nécessaire de le niveler en ajoutant entre les surélévations une quantité de colle supplémentaire qui introduit entre l'armature du boîtier et le circuit électrique une résistance thermique. Les colles couramment utilisées ont une conductivité thermique comprise entre 0,1 cal/cm s °C et 0,01 cal/cm s °C et les surélévations peuvent être, par exemple, de 4/100 mm. Aussi, une planéité du fond de la cuvette permet une dissipation de la chaleur ne nuisant pas au bon fonctionnement des circuits électriques encapsulés.

Pour fondre la cire, on place l'ensemble pièce en cire-produit réfractaire dans un four où l'étape de chauffage de l'ensemble pièce en cire-produit réfractaire est, préférentiellement, réalisée à une température comprise entre 150°C et 300°C, les couches de produit réfractaire étant suffisamment rigides pour conserver leur forme sans le soutien de la pièce en cire. Néanmoins, la force de cohésion des grains des couches du produit réfractaire doit être renforcée par un frittage dudit produit réfractaire pour supporter le coulage d'alliage. L'étape du frittage du produit réfractaire est, de préférence, réalisée à une température voisine de 1000°C. Les opérations consistant à fondre la cire et à fritter le produit réfractaire s'effectuent sur plusieurs armatures simultanément. Le moule est, alors, insensible aux fortes températures imposées par le coulage du métal constituant l'armature.

Le métal est, en effet, coulé à une température comprise entre 1500°C et 1650°C, ce qui donne au métal une faible viscosité et évite son oxydation. Ledit moule en poduit réfractaire est, de préférence, porté à une température voisine de la température du métal coulé avant l'étape du coulage du métal, c'est-à-dire que le moule en produit réfractaire est porté à une température comprise entre 1500°C et 1650°C. Ainsi, lors du coulage du métal, celui-ci n'est pas refroidi par le moule et il se répartit homogènement dans tout le moule. Aucun bouchon de métal solidifié par le moule ne vient gêner la circulation du reste du métal, bien que l'épaisseur interne du moule ou l'épaisseur de l'armature est comprise entre 1 mm et 2 mm.

Dans un mode préférentiel de réalisation, le produit réfractaire comporte au moins 40% en poids d'alumine, de 20% à 40% en poids de zircone, entre 0% et 40% en poids de silice. De tels produits réfractaires ne fluent pas à la température où le métal est coulé. Pratiquement, la proportion d'alumine est d'autant plus grande que la température où le métal est coulé est importante.

La solution de produit réfractaire est, préférentiellement, basique, ce qui est obtenu par addition, par exemple de soude, de silicate de soude, de phosphate de chaux ou d'aluminate de chaux dans la solution. Une solution basique permet d'augmenter la contrainte de cisaillement seuil et donc l'adhérence du produit réfractaire.

Le métal coulé est choisi, de préférence, parmi les alliages fer-nickel-cobalt ou les alliages dont la composition comporte 65% à 75% en poids de fer, 9% à 11% en poids de nickel, 17% à 19% en poids de chrome. L'alliage fer-nickel-zinc le plus couramment utilisé a une composition comportant 17% en poids de cobalt, 54% en poids de nickel et 29% en poids de fer. La composition de l'alliage comportant du fer, du nickel et du chrome peut également comprendre en plus faible quantité du carbone, du manganèse, du phosphore, du soufre et de la silice, la proportion de ces derniers constituants ne dépassant pas 4% en poids de la composition.

Pendant l'opération d'injection, la cire a tendance à perdre ses dimensions originales, c'est-à-dire que la cire effectue un retrait. Ce retrait est uniforme et la cire est choisie pour n'opérer qu'un retrait compris entre 0,5% et 1%. De même, lors du frittage, sous l'action de la température, les couches de produit réfractaire rétrécissent leurs dimensions. Ce dernier retrait est d'environ 1%. La cire est fondue avant l'opération de frittage afin que ce retrait puisse se faire librement sans la contrainte de la cire. En effet, la cire conservée pendant le frittage gênerait le retrait du produit réfractaire et le moule se fenderait. Pendant le séchage, les produits réfractaires ne rétrécissent pas.

Ce procédé permet, donc, d'obtenir les armatures de boîtier dont les formes géométriques sont très précisément celles prévues, tout en utilisant des moyens de trempage et de montée en température utilisables pour plusieurs armatures simultanément.

La présente invention sera mieux comprise à l'aide des figures suivantes données à titre non limitatif, qui représentent :

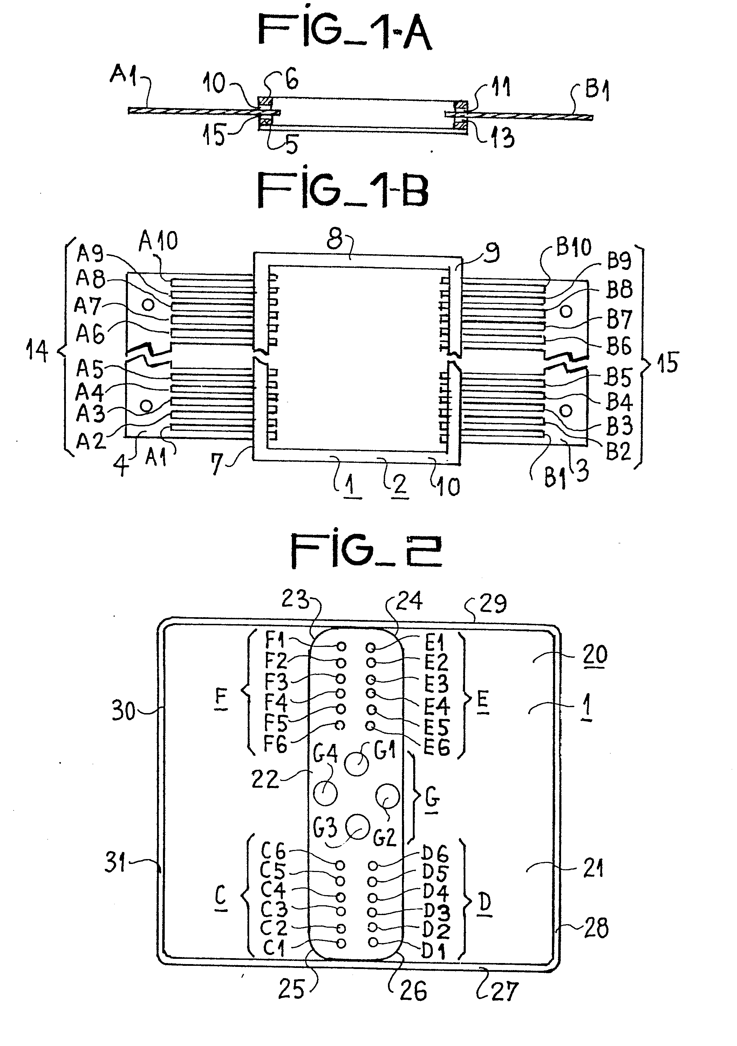

. - les figures 1A et 1B, un premier exemple de boîtier réalisé selon le procédé de fabrication de l'invention,

- la figure 2, un deuxième exemple de boîtier réalisé selon le procédé de fabrication de l'invention,

- la figure 3, une coupe d'un exemple de réalisation d'un compartiment où la cire est injectée.

Les figures 1A et 1B représentent un premier exemple de boîtier réalisé selon le procédé de fabrication de l'invention. La figure 1A est une vue de dessus du boîtier tandis que la figure 1B est une coupe longitudinale du boîtier. L'armature (1) dudit boîtier est le cadre (2). Le cadre (2) est métallique et carré. Il comporte 4 parois latérales (7, 8, 9, 10) de longueur 32 mm environ. Leur épaisseur est environ 1 mm. Deux parois latérales (7, 9) placées en vis-à-vis comportent des trous cylindriques (10, 11) les traversant selon leur épaisseur depuis l'extérieur du cadre jusqu'à son périmètre intérieur et espacés de 1,27 mm. Un couvercle (4) est brasé sur la face inférieure (5) du cadre (2). La fermeture dudit boîtier sera effectuée, ensuite, par soudure d'un deuxième couvercle sur la face supérieure (6) du cadre (2).

Des fils de connexion $(A_1, A_2, ..., A_{10})$ et $(B_1, B_2, ..., B_{10})$ sont répartis en deux groupes. Le premier groupe des fils de connexion $(A_1, A_2, ..., A_{10})$ est disposé dans les trous cylindriques (10) d'une paroi latérale (7), chacun des fils de connexion étant fixé dans un trou cylindrique (10) par l'intermédiaire d'une perle de verre (12). Les fils de connexion $(A_1, A_2, ..., A_{10})$ sont fixés sur une rive de connexion (4) parallèlement les uns aux autres constituant ainsi une grille de connexions (14) au pas de 1,27 mm.

De même, le deuxième groupe de fils de connexion $(B_1, B_2, ..., B_{10})$ est disposé dans les trous cylindriques (11) de la paroi latérale (9) par une perle de verre (13) et sont fixés sur une rive (3) constituant la grille de connexion (15) au pas de 1,27 mm.

La figure 2 représente un deuxième exemple de boîtier réalisé selon le procédé de fabrication de l'invention. La figure 2 est une vue de dessus dudit boîtier. L'armature (1) dudit boîtier est une cuvette (20) constituée d'un fond (21) et de quatre parois latérales (27, 28, 29, 30) formant un rectangle, les parois (27 et 29) ayant une longueur de 65 mm environ et les parois (28 et 30) ayant une longueur de 55 mm environ. L'épaisseur des parois (27, 28, 29, 30) est de 1 mm. Le fond (21) de la cuvette (20) comporte un renfoncement (22) rectangulaire de dimensions 14,6 mm x 55 mm dont les cotes de longueur 55 mm sont parallèles aux parois (28 et 30). Chacun des angles (23, 24, 25, 26) du renfoncement (22) est arrondis et a un rayon de courbure de 5 mm. Le fond (21) a une épaisseur constante de 1,5 mm. Un couvercle sera soudé après montage des circuits électriques sur la face supérieure (31) des parois (27, 28, 29, 30) de la cuvette (20).

Des trous cylindriques sont percés verticalement sur le fond (21) de la cuvette (20), lequel est horizontal et plus particulièrement dans le renfoncement (22) du fond (21). La tolérance sur la position des trous et sur leur diamètre est de 5/100 mm. Lesdits trous cylindriques se décomposent en quatre rangées (C, D, E, F) de six trous cylindriques fins ($C_1$, ..., $C_6$); ($D_1$, ..., $D_6$); ($E_1$, ..., $E_6$); ($F_1$, ..., $F_6$) et une série G de quatre gros trous cylindriques ($G_1$, ..., $G_4$) qui sont disposés en losange. Les gros trous cylindriques ont un diamètre d'environ 4 mm et les trous cylindriques fins d'environ 1,7 mm. Deux rangées C et D sont placées d'une part du losange de la série G localisé au centre du renfoncement (22), tandis que les rangées E, F sont placées de l'autre côté du losange de la série G. Les trous cylindriques ($C_1$, ..., $C_6$) de la rangée C sont alignés parallèlement aux trous cylindriques ($D_1$, ..., $D_6$) de la rangée D. De même, les trous cylindriques ($E_1$, ..., $E_6$) de la rangée E sont alignés en vis-à-vis des trous cylindriques ($F_1$, ..., $F_6$) de la rangée F.

La cuvette (20) a donc une forme relativement compliquée bien que des formes de ce type soient couramment utilisées pour l'encapsulation de circuit micro-électronique hybride. Le procédé de l'invention permettant de façonner des formes compliquées dans une matière facilement modelable au lieu de travailler et usiner une pièce métallique qui doit être réaliser avec précision et ayant de faibles épaisseurs.

10

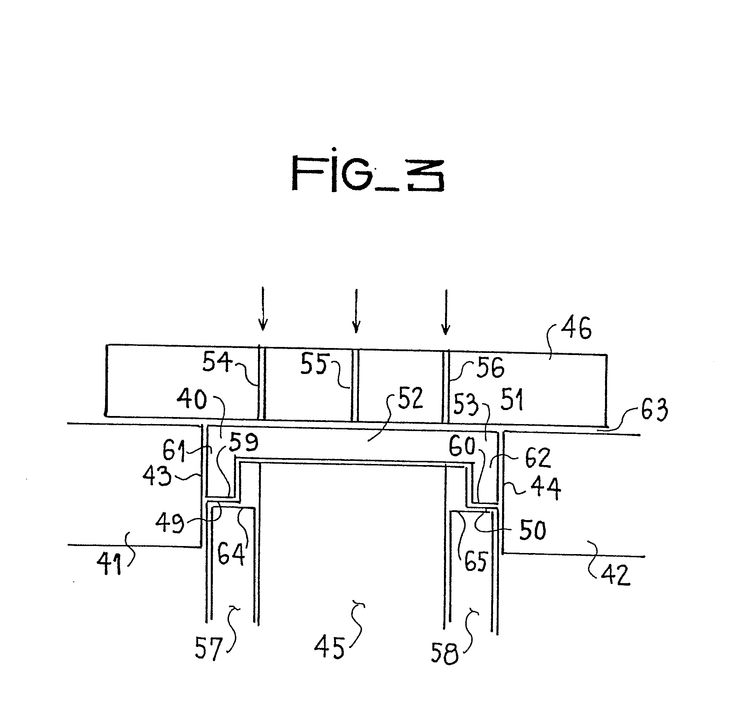

La figure 3 représente une coupe d'un exemple de réalisation d'un compartiment métallique où la cire (52) est injectée afin de constituer la pièce en cire (53). Le compartiment (40) est délimité latéralement par quatre éléments métalliques (41, 42) offrant respectivement une surface lisse (43, 44) en vis-à-vis du compartiment (40) et verticalement par un socle (45) et une unité métallique (46) dont la surface inférieure (51) est lisse et horizontale étant en vis-à-vis du compartiment (40). Le socle (45) est en contact avec le compartiment (40) par sa face supérieure (47) qui est plane en son centre (48) et qui comporte des affaissements (49, 50) sur toute sa périphérie. Ainsi, la pièce en cire (53) modelée dans le compartiment (40) sera en forme de cuvette rectangulaire dont les rebords latéraux (61, 62) sont dirigés vers le bas étant constitués par la cire qui s'introduit dans les affaissements (49, 50). La cire (52) est injectée dans le compartiment (40) par des trous (54, 55, 56) percés à travers l'unité métallique (46). Les éjecteurs (57, 58) coulissent à l'intérieur du socle (45). Lorsque la pièce en cire (53) est modelée à l'intérieur du compartiment (40), les éjecteurs (57, 58) montent, repoussant la pièce en cire (53) sur les faces supérieures (64, 65) des éjecteurs (57, 58) effectuant une poussée sur les faces supérieures (59, 60) des rebords latéraux (61, 62), ce qui soulève l'unité métallique (46) libérant un espace (63) par lequel la pièce en cire (53) sort.

11

R E V E N D I C A T I O N S

1. Procédé de fabrication d'un boîtier pour encapsulation de composants formant un circuit électrique, ce boîtier comportant une armature supportant les fils de connexion du circuit électrique et au moins un couvercle soudé sur l'armature, caractérisé en ce que l'on réalise une pièce en cire (53) ayant la forme géométrique de l'armature (1) du boîtier, au moins une couche d'une solution d'un produit réfractaire étant ensuite déposée sur la surface de la pièce en cire (53) puis séchée afin de durcir ladite couche par évaporation du solvant, l'ensemble pièce en cire-produit réfractaire étant ensuite chauffé pour fondre la cire, le produit réfractaire étant ensuite fritté afin de constituer un moule de l'armature (1) dans lequel un métal est coulé pour réaliser l'armature (1).

2. Procédé de fabrication selon la revendication 1, caractérisé en ce que le produit réfractaire de la solution de la première couche déposée sur la pièce en cire (53) est constitué de grains de granulométrie comprise entre 1 $\mu$m et 10 $\mu$m.

3. Procédé de fabrication selon l'une des revendications 1 ou 2, caractérisé en ce que l'on dépose entre 10 et 15 couches de produit réfractaire.

4. Procédé de fabrication selon l'une des revendications 1 à 3, caractérisé en ce que la pièce en cire (53) est réalisée par injection de cire (52) dans un compartiment métallique (40), des éjecteurs (57, 58) sortant la pièce en cire (53) dudit compartiment (40) par poussée sur les faces supérieures (59, 60) des parois de la pièce en cire (53).

5. Procédé de fabrication selon l'une des revendications 1 à 4, caractérisé en ce que l'étape de chauffage de l'ensemble pièce en cire-produit réfractaire est réalisée à une température comprise entre 150°C et 300°C.

6. Procédé de fabrication selon l'une des revendications 1 à 5, caractérisé en ce que l'étape de frittage du produit réfractaire est réalisée à une température voisine de 1000°C.

. 7. Procédé de fabrication selon l'une des revendications 1 à 6, caractérisé en ce que ledit moule en produit réfractaire est porté à une température voisine de la température du métal coulé avant l'étape du coulage du métal.

8. Procédé de fabrication selon l'une des revendications 1 à 7, caractérisé en ce que le produit réfractaire comporte au moins 40% en poids d'alumine, de 20% à 40% en poids de zircone, entre 0% et 40% en poids de silice.

9. Procédé de fabrication selon l'une des revendications 1 à 8, caractérisé en ce que la solution de produit réfractaire est basique.

10. Procédé de fabrication selon l'une des revendications 1 à 9, caractérisé en ce que le métal coulé est choisi parmi les alliages fer-nickel-cobalt ou les alliages dont la composition comporte 65% à 75% en poids de fer, 9% à 11% en poids de nickel, 17% à 19% en poids de chrome.

FIG_1-A

FIG_1-B

FIG_2

## FIG_3

Office européen
des brevets

**RAPPORT DE RECHERCHE EUROPEENNE**

Numéro de la demande

EP 82 40 1273

## DOCUMENTS CONSIDERES COMME PERTINENTS

| Catégorie | Citation du document avec indication. en cas de besoin, des parties pertinentes | Revendication concernée | CLASSEMENT DE LA DEMANDE (Int. Cl. 3) |
|---|---|---|---|
| Y | FR-A-2 045 024 (LIGNES TELEGRAPHIQUES ET TELEFONIQUES) *Revendications 1-6; figures 1a,1b* | 1 | B 22 C 9/04 H 01 L 21/48 |
| Y | US-A-3 022 556 (G.R.GARDNER) *Colonne 4, lignes 65-75; colonne 5, lignes 1-15* | 1 | |
| Y | FR-A-1 585 162 (BROWN) *Page 20, lignes 8-10; résumé B3,B6* | 2,3,5, 6 | |
| Y | FR-A-1 536 487 (GENERAL ELECTRIC CY) *Page 2, colonne de droite, lignes 17-61; page 3, colonne de gauche, lignes 1-36* | 1,6 | |
| | | | DOMAINES TECHNIQUES RECHERCHES (Int. Cl. 3) |
| Y | US-A-3 239 897 (N.G.LIRONES) *Figures 1,2; colonne 4, lignes 48-75; colonne 5, lignes 1-64* | 3,5,6 | B 22 C |

Le présent rapport de recherche a été établi pour toutes les revendications

| Lieu de la recherche | Date d'achèvement de la recherche | Examinateur |
|---|---|---|
| LA HAYE | 15-10-1982 | MAILLIARD A.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

OEB Form 1503 03 82